# EUROPÄISCHE PATENTANMELDUNG

(11) **EP 2 246 708 A1**
(43) Veröffentlichungstag der Anmeldung: **03.11.2010**
(21) Anmeldenummer: 09006004.7
(22) Anmeldetag: 30.04.2009
(51) Int. Cl.: G01R 31/28, H01L 21/66

(54) **Verfahren zur Erstellung einer Defektkarte von auf einem Träger, insbesondere einem Halbleiter-Wafer, befindliche Einzelkomponenten, insbesondere Halbleiter-Bauelementen**

(71) Anmelder: Micronas GmbH, 79108 Freiburg i. Br. (DE)
(72) Erfinder: Zimmer, Hans-Günter, 79276 Reute (DE); Krause, Jörg, 79102 Freiburg (DE)
(74) Vertreter: Koch Müller Patentanwaltsgesellschaft mbH

(57) **Zusammenfassung**

Die Erfindung betrifft ein Verfahren zur Erstellung einer Defektkarte von auf einem Träger, insbesondere einem Halbleiter-Wafer befindlichen Einzelkomponenten, insbesondere HalbleiterBauelementen, bei dem zunächst mittels eines Messvorganges, insbesondere mittels Proben defekte Einzelkomponenten identifiziert werden. Erfindungsgemäß werden folgende Verfahrensschritte durchgeführt:
- Erstellen einer ersten und zweiten Defektkarte, indem die defekten Einzelkomponenten disjunkt der ersten und zweiten Defektkarte derart zugeordnet werden, dass auf der ersten Defektkarte nur diejenigen defekten Einzelkomponenten als defekt klassifiziert werden, deren angrenzenden Einzelkomponenten eine Umgebung mit einer Defektdichte bis zu einem ersten Wert (δ₁) bilden und auf der zweiten Defektkarte die bei der Erstellung der ersten Defektkarte nicht berücksichtigten defekten Einzelkomponenten als defekt klassifiziert werden,
- Erstellen einer dritten Defektkarte indem auf der zweiten Defektkarte weitere Einzelkomponenten als defekt klassifiziert werden, deren angrenzenden Einzelkomponenten eine Umgebung mit mindestens einer Defektdichte mit einem zweiten Wert (δ₂) bilden, der kleiner als der erste Wert (δ₁) ist, und
- Erstellen einer vierten Defektkarte durch Vereinigen der dritten Defektkarte mit der ersten Defektkarte.

## Beschreibung

Die Erfindung betrifft ein Verfahren zur Erstellung einer Defektkarte von auf einem Träger, insbesondere einem Halbleiter-Wafer befindlichen Einzelkomponenten, insbesondere Halbleiter-Bauelementen gemäß Oberbegriff des Patentanspruchs 1 sowie einen Prober, insbesondere einen Wafer-Prober zur Durchführung des erfindungsgemäßen Verfahrens.

Mit zunehmender Komplexität technischer Produkte, insbesondere von Halbleiter-Bauelementen, steigen die Qualitätsanforderungen im Herstellungsprozess, in deren Verlauf daher in unterschiedlichen Fertigungsstufen Funktions- oder Parameterprüfungen durchzuführen sind.

In der Regel werden Halbleiter-Bauelemente, bzw. integrierte Schaltkreise (IC) auf sogenannten Wafern, bspw. aus Silizium hergestellt, die üblicherweise eine große Vielzahl von sogenannten Chips aufweisen, die am Ende der Produktion nach dem Zerteilen des Wafers den Halbleiter-Produkten entsprechen. Die Größe der einzelnen Chips und die Anzahl der Chips pro Wafer werden durch das Design und die Technologie vorgegeben.

Am Ende der Halbleiter-Herstellung, jedoch in der Regel vor dem Zerteilen des Halbleiter-Wafers, werden die Chips auf ihre Funktionsfähigkeit in einem Messvorgang, Proben genannt, getestet. Dieses Proben erfolgt in einer Messapparatur, Prober genannt, bei welchem defekte Chips mit Tinte markiert, auch Inken genannt, oder deren x-y-Orts-Daten auf dem Wafer in einem Speicher eines Probers gespeichert werden. In diesem Zusammenhang ist das Verhältnis der funktionierenden Chips zu der Gesamtzahl der hergestellten Chips einer der wesentlichen Parameter, der u. a. die Wirtschaftlichkeit der Halbleiterproduktion bestimmt.

Aufgrund des komplexen Herstellungsverfahrens treten bspw. systematische Fehler in eingegrenzten Bereichen des Wafers gehäuft auf, während Chips mit zufälligen bzw. stochastischen Fehler verteilt über den Halbleiter-Wafer auftreten. Um möglichst alle defekten Chips, also auch solche mit einem latenten Fehler, der also mit großer Wahrscheinlichkeit zu einem späteren Ausfall des Bauelements führt, zu erfassen, werden statistische Methoden verwandt.

Die auf einem Halbleiter-Wafer prozessierten Chips sind in Reihen und Spalten angeordnet, so dass, ausgenommen im Randbereich des Wafers, jeder Chip von acht anderen Chips umgeben ist. Treten bspw. in einem Bereich des Wafers defekte Chips gehäuft in sogenannten Clusters auf, also mit hoher Defektdichte, ist die Wahrscheinlichkeit groß, dass auch direkt benachbarte Chips fehlerhaft sind, da geclusterte Fehler auf einen systematischen Fehler hindeuten. Dies wird in einer sogenannten x/8-Regel umgesetzt, indem bei einem als defekt erkannten Chip, von dessen umgebenden Chips ebenfalls x Chips als fehlerhaft erkannt sind, auch die restlichen (8-x) Chips als fehlerhaft markiert werden, bspw. durch Nachinken. So besagt bspw. die 3/8-Regel, dass bei drei defekten Chips in der Umgebung eines defekten Chips auch die restlichen diesen Chip umgebenden fünf (=8-3) Chips als defekt markiert werden. Dieser Vorgang kann mehrmals wiederholt werden, wobei die nachträglich geinkten Chips als defekt in diese Iteration aufgenommen werden.

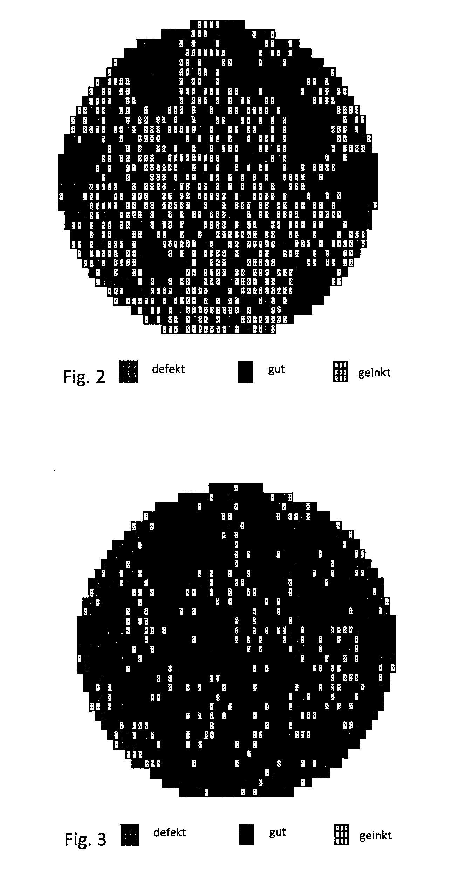

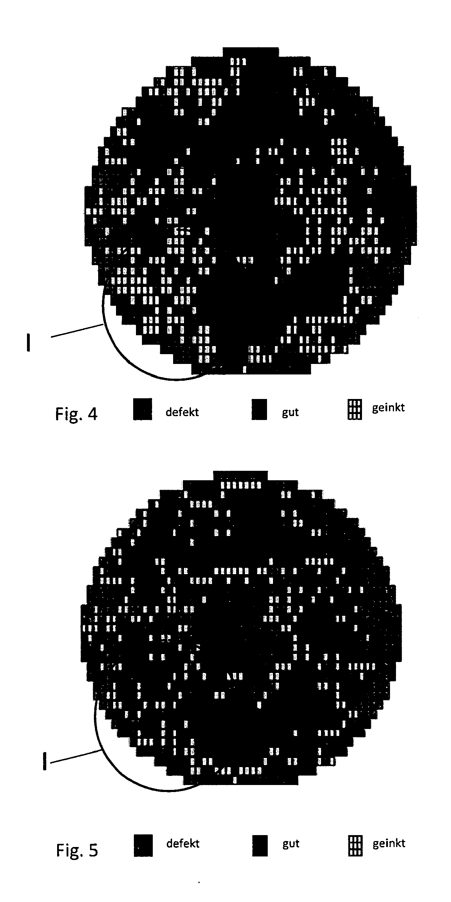

Der Nachteil eines solchen Verfahrens liegt einmal darin, dass Ränder von zusammenhängenden Gebieten nicht erkannt werden, und zum anderen, dass hinreichend hohe über dem Wafer statistisch verteilte Defektdichten zur Markierung aller sich in dem Gesamtgebiet befindlichen Chips als defekt führt. Beispiele hierfür sind in den Figuren 2 und 4 gezeigt, in den mit dem Proben defekt erkannte Chips markiert sind und ebenso die mit dem beschriebenen Verfahren nachträglich geinkten Chips.

So wird in Figur 2 ein bspw. ein Wafer mit einer gleichmäßig verteilten Defektdichte von 3,0/CM² gezeigt, wobei mit der beschriebenen 3/8-Regel nahezu das Gesamtgebiet zugeinkt wird.

Ferner zeigt die Figur 4 ein eingekreistes Gebiet I, bei dem mit dem beschriebenen Verfahren die Ränder von zusammenhängenden Gebieten nicht erkannt und daher ebenfalls zugeinkt werden.

Aufgabe der Erfindung ist es, ein verbessertes Verfahren zur Erstellung einer Defektkarte anzugeben, das die oben genannten Nachteile vermeidet sowie einen Prober zur Durchführung dieses Verfahrens.

Diese Aufgabe wird gelöst durch ein Verfahren mit den Merkmalen des Patentanspruchs 1.

Bei einem solchen Verfahren werden in einem ersten Verfahrensschritt zunächst eine erste und zweite Defektkarte erstellt, indem die defekten Einzelkomponenten disjunkt der ersten und zweiten Defektkarte derart zugeordnet werden, dass auf der ersten Defektkarte nur diejenigen defekten Einzelkomponenten als defekt klassifiziert werden, deren angrenzenden Einzelkomponenten eine Umgebung mit einer Defektdichte bis zu einem ersten Wert δ₁ bilden und auf der zweiten Defektkarte die bei der Erstellung der ersten Defektkarte nicht berücksichtigten defekten Einzelkomponenten als defekt klassifiziert werden, wobei dieser erste Wert δ₁ so gewählt ist, dass damit Einzelkomponenten mit zufällig verteilten Fehler, also mit geringer Fehlerdichte erfasst werden. Vorzugsweise beträgt dieser erste Wert δ₁ als Defektdichte 3/8 (gemäß der oben erläuterten Regel).

Im folgenden Verfahrensschritt wird aus der zweiten Defektkarte eine dritte Defektkarte erstellt, indem auf der zweiten Defektkarte weitere Einzelkomponenten als defekt klassifiziert werden, deren angrenzenden Einzelkomponenten eine Umgebung mit mindestens einer Defektdichte mit einem zweiten Wert δ₂ bilden, der kleiner als der erste Wert δ₁ ist. Dies bedeutet, dass bei einem ersten Wert δ₁ von 3/8 vorzugsweise für den zweiten Wert δ₂ 2/8 (gemäß der oben beschriebenen x/8-Regel) gewählt wird, so dass diese dritte Defektkarte Gebiete mit hohen Fehlerraten identifiziert.

Schließlich wird in einem letzten Verfahrensschritt durch Vereinigen der dritten Defektkarte mit der ersten Defektkarte eine vierte Defektkarte erstellt. Damit werden die Gebiete mit zufällig verteilten fehlerhaften Einzelkomponenten, also mit geringen Fehlerdichten wieder hinzugefügt, infolgedessen nicht alle Einzelkomponenten solcher Gebiete fälschlicherweise als defekt klassifiziert werden, also nicht zugeinkt werden.

Durch die Trennung der Daten von Gebieten mit Einzelkomponenten mit geringen Fehlerdichten und solchen mit hohen Fehlerdichten und der gesonderten Behandlung der Gebiete mit hohen Fehlerraten werden Ränder von zusammenhängenden Gebieten mit fehlerhaft identifizierten Einzelkomponenten berücksichtigt.

Gemäß einer vorteilhaften Weiterbildung der Erfindung werden nach dem Erstellen der vierten Defektkarte diejenigen Einzelkomponenten, die zusätzlich als defekt klassifiziert wurden, wieder als nichtdefekt klassifiziert, wenn deren angrenzenden Einzelkomponenten eine Umgebung mit nichtdefekten Einzelkomponenten bilden. Damit kann noch eine bessere Abgrenzung von zusammenhängenden Gebieten von defekt identifizierten Einzelkomponenten erzielt werden.

Bei einer Weiterbildung der Erfindung wird eine fünfte Defektkarte erstellt, indem zusätzlich diejenigen Einzelkomponenten als defekt klassifiziert werden, deren angrenzenden Einzelkomponenten eine Umgebung mit einer Defektdichte mit einem dritten Wert δ₃ aufweist, der größer als der erste Wert δ₁ ist, vorzugsweise wird hierfür ein Wert δ₃ von 5/8 (gemäß der x/8-Regel) vorgeschlagen. Mit dieser fünften Defektkarte soll mit hoher Sicherheit erreicht werden, dass alle statistisch möglichen defekten Einzelkomponenten klassifiziert werden.

Besonders vorteilhaft ist es, die defekten Einzelkomponenten als auch die zusätzlich als defekt klassifizierten Einzelkomponenten optisch zu markieren, vorzugsweise mittels eines Farbpunktes.

Das erfindungsgemäße Verfahren kann bevorzugt für Halbleiter-Wafer als Träger mit Halbleiter-Bauelementen, insbesondere integrierten Schaltungen als Halbleiterbauelemente verwendet werden.

Zur Durchführung des erfindungsgemäßen Verfahrens wird ein Prober, insbesondere ein Wafer-Prober mit den Merkmalen des Patentanspruchs 11 vorgeschlagen.

Die Erfindung wird nachfolgend anhand eines Ausführungsbeispiels unter Bezugnahme auf die beigefügten Figuren ausführlich beschrieben. Es zeigen:
- Figur 1: ein Ablaufdiagramm zur Erstellung einer erfindungsgemä- ßen Defektkarte,
- Figur 2: eine Defektkarte eines geprobten Halbleiter-Wafers nach dem Stand der Technik,
- Figur 3: eine gemäß der Erfindung erstellte Defektkarte des nach Figur 2 geprobten Halbleiter-Wafers,
- Figur 4: eine Defektkarte eines weiteren geprobten Halbleiter- Wafers nach dem Stand der Technik, und
- Figur 5: eine gemäß der Erfindung erstellte Defektkarte des nach Figur 4 geprobten Halbleiter-Wafers.

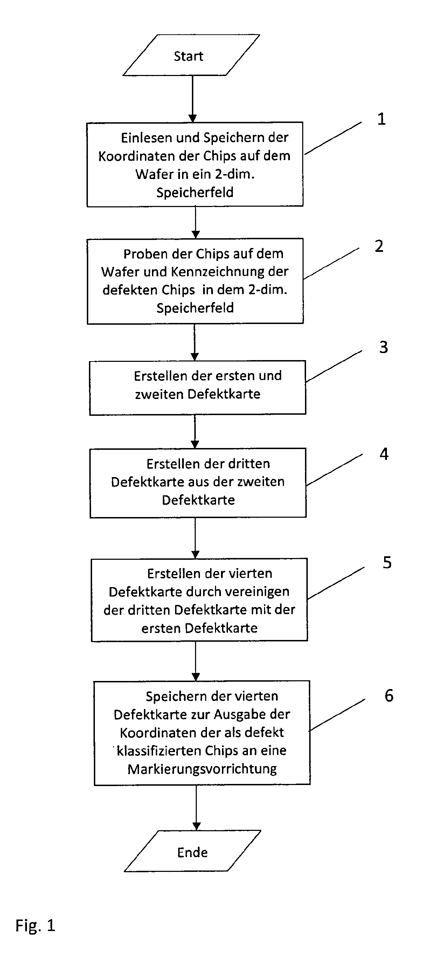

Das erfindungsgemäße Verfahren zur Erstellung einer Defektkarte von auf einem Halbleiter-Wafer hergestellten Halbleiter-Bauelementen, hier Chips genannt, wird anhand des Ablaufdiagramms nach Figur 1 erläutert.

Die nach diesem Verfahren hergestellten Defektkarten solcher Halbleiter-Wafer zeigen die Figuren 3 und 5. Zum Vergleich werden auch Defektkarten gemäß den Figuren 2 und 4 gezeigt, die mit einem bekannten Verfahren, nämlich mit der eingangs erläuterten 5/8-Regel erzeugt wurden.

In diesen in den Figuren 2 bis 5 dargestellten Defektkarten werden die durch Proben identifizierten defekten Chips im Unterschied zu den nicht-defekten (in den Figuren als "gut" bezeichnet) unterschiedlich dargestellt. Auch diejenigen Chips, die mit dem bekannten Verfahren gemäß der 5/8-Regel bzw. dem neuen Verfahren als defekt klassifiziert werden, sind in den Figuren 2 bis 5 gesondert zu erkennen und als "geinkt" bezeichnet.

Nach Figur 1 startet das erfindungsgemäße Verfahren mit dem Einlesen und Speichern der Koordinaten der auf einem Halbleiter-Wafer prozessierten Chips in einem 2-dimensionalen Speicherfeld einer Steuereinrichtung eines Wafer-Probers (Verfahrensschritt 1).

In einem anschließenden Verfahrensschritt 2 werden die Chips auf dem Halbleiter-Wafer geprobt und die defekten Chips in dem 2-dimensionalen Speicherfeld als defekt gekennzeichnet. In den Figuren 1 bis 4 sind solche Chips als "defekt" gekennzeichnet.

Anschließend wird in einem dritten Verfahrensschritt 3 sowohl eine erste als auch eine zweite Defektkarte erzeugt, indem die beim Proben identifizierten defekten Chips disjunkt der ersten und zweiten Defektkarte derart zugeordnet werden, dass auf der ersten Defektkarte nur diejenigen defekten Chips als defekt klassifiziert werden, deren angrenzenden acht Chips eine Umgebung mit einer Defektdichte bis zu einem ersten Wert δ₁, hier 3/8 gemäß der eingangs erläuterten x/8-Regel, bilden und auf der zweiten Defektkarte die bei der Erstellung der ersten Defektkarte nicht berücksichtigten ebenfalls beim Proben identifizierten defekten Chips als defekt klassifiziert werden. Dieser erste Wert δ₁ ist so gewählt, dass damit Chips mit zufällig verteilten Fehler, also mit geringer Fehlerdichte erfasst werden.

In einem vierten Verfahrensschritt 4 wird aus der zweiten Defektkarte eine dritte Defektkarte erstellt, indem auf der zweiten Defektkarte weitere Chips als defekt klassifiziert werden, deren angrenzenden Chips eine Umgebung mit mindestens einer Defektdichte mit einem zweiten Wert δ₂ von 3/8 gemäß der x/8-Regel bilden, der kleiner als der erste Wert δ₁ ist. Dies bedeutet, dass der zweite Wert δ₂ so gewählt wird, dass mit dieser dritten Defektkarte Gebiete mit hohen Fehlerraten identifiziert werden.

Anschließend wird in einem fünften Verfahrensschritt 5 eine vierte Defektkarte durch vereinigen der dritten Defektkarte mit der ersten Defektkarte erstellt. Damit werden die Gebiete mit zufällig verteilten fehlerhaften Chips, also mit geringen Fehlerdichten wieder hinzugefügt, infolgedessen nicht alle Chips solcher Gebiete fälschlicherweise als defekt klassifiziert werden.

Schließlich wird in einem letzten Verfahrensschritt 6 die vierte Defektkarte zwecks Ausgabe der Koordinaten der als defekt klassifizierten Chips an eine Markierungsvorrichtung des Wafer-Probers gespeichert, so dass die als defekt klassifizierten Chips, wie in den Figuren 3 und 5 dargestellt ist, geinkt werden können.

Figur 3 zeigt eine mit dem erfindungsgemäßen Verfahren erstellte vierte Defektkarte eines Halbleiter-Wafers im Vergleich zu einer mit dem bekannten Verfahren der 5/8-Regel erstellten Defektkarte des gleichen Halbleiter-Wafers gemäß Figur 2, also mit der gleichen Verteilung der beim Proben identifizierten defekten Chips.

Die Defektkarte nach Figur 2 ist mit dem bekannten Verfahren der 5/8-Regel erstellt, indem also die nach diesem Verfahren klassifizierten Chips ebenfalls geinkt sind. Aus dieser Figur 2 ist zu erkennen, dass nahezu das gesamte Gebiet zugeinkt ist.

Im Gegensatz hierzu zeigt Figur 3, dass durch das erfindungsgemäße Verfahren Gebiete mit niedrigen und zufällig verteilen Defektraten nicht zugeinkt werden, sondern Gebiete mit höheren Defektraten als der erste Wert δ₁ erkannt werden und in diesen Gebieten weitere Chips als defekt klassifiziert werden.

Dass Ränder von zusammenhängenden Gebieten von defekten Chips mit dem erfindungsgemäßen Verfahren besser erkannt werden, zeigt die vierte Defektkarte nach Figur 5 im Vergleich zu der Defektkarte nach Figur 4, deren Defektkarte wieder mit der bekannten 5/8-Regel erstellt ist. Auch diesen beiden Defektkarten liegt der gleiche Halbleiter-Wafer zugrunde. Der Unterschied der beiden Defektkarten ist insbesondere in dem eingekreisten Gebiet I deutlich zu erkennen. Gemäß Figur 4 werden die Ränder der Gebiete mit hohen Defektraten, die sich einmal im Zentrum des Wafers und zum anderen am Rand des Wafers befindet, nicht erkannt und deshalb zugeinkt. In dem Gebiet I der Figur 5 ist jedoch die Trennung dieser beiden Gebiete deutlich zu erkennen.

Zur Verbesserung der Erkennung der Ränder von zusammenhängenden Gebieten können nach dem Erstellen der vierten Defektkarte diejenigen Chips, die zusätzlich als defekt klassifiziert wurden, wieder als nichtdefekt klassifiziert, d. h. wieder entinkt werden, wenn deren angrenzenden Chips eine Umgebung mit nichtdefekten Chips bilden.

Um mit hoher Sicherheit zu erreichen, dass alle statistisch möglichen defekten Chips klassifiziert werden, kann aus der vierten Defektkarte vor Durchführung des letzten Verfahrensschrittes 6 eine fünfte Defektkarte erstellt werden, indem zusätzlich diejenigen Chips als defekt klassifiziert werden, deren angrenzenden Chips eine Umgebung mit einer Defektdichte mit einem dritten Wert δ₃ von 5/8 aufweist, der also größer als der erste Wert δ₁ von 3/8 ist.

Das erfindungsgemäße Verfahren kann nicht nur bei der Halbleiterherstellung verwendet werden, sondern ist auch in vielen anderen Technikbereichen einsetzbar, bei denen bspw. auf Glas-oder Keramik-Substraten gleichzeitig eine Vielzahl von Einzelkomponenten hergestellt werden, insbesondere auch in der Biotechnologie.

## Patentansprüche

1. Verfahren zur Erstellung einer Defektkarte von auf einem Träger, insbesondere einem Halbleiter-Wafer, befindlichen Einzelkomponenten, insbesondere Halbleiter-Bauelementen, bei dem zunächst mittels eines Messvorganges, insbesondere mittels Proben defekte Einzelkomponenten identifiziert werden,
**dadurch gekennzeichnet, dass** folgende Verfahrensschritte durchgeführt werden:
- Erstellen einer ersten und zweiten Defektkarte, indem die defekten Einzelkomponenten disjunkt der ersten und zweiten Defektkarte derart zugeordnet werden, dass auf der ersten Defektkarte nur diejenigen defekten Einzelkomponenten als defekt klassifiziert werden, deren angrenzenden Einzelkomponenten eine Umgebung mit einer Defektdichte bis zu einem ersten Wert (δ₁) bilden und auf der zweiten Defektkarte die bei der Erstellung der ersten Defektkarte nicht berücksichtigten defekten Einzelkomponenten als defekt klassifiziert werden,
- Erstellen einer dritten Defektkarte indem auf der zweiten Defektkarte weitere Einzelkomponenten als defekt klassifiziert werden, deren angrenzenden Einzelkomponenten eine Umgebung mit mindestens einer Defektdichte mit einem zweiten Wert (δ₂) bilden, der kleiner als der erste Wert (δ₁) ist, und
- Erstellen einer vierten Defektkarte durch Vereinigen der dritten Defektkarte mit der ersten Defektkarte.

2. Verfahren nach Anspruch 1,
**dadurch gekennzeichnet, dass** nach dem Erstellen der vierten Defektkarte diejenigen Einzelkomponenten, die zusätzlich als defekt klassifiziert wurden, wieder als nichtdefekt klassifiziert werden, wenn deren angrenzenden Einzelkomponenten eine Umgebung mit nichtdefekten Einzelkomponenten bilden.

3. Verfahren nach Anspruch 1 oder 2,
**dadurch gekennzeichnet, dass** eine fünfte Defektkarte erstellt wird, indem zusätzlich diejenigen Einzelkomponenten als defekt klassifiziert werden, deren angrenzenden Einzelkomponenten eine Umgebung mit einer Defektdichte mit einem dritten Wert (δ₃) aufweist, der größer als der erste Wert (δ₁) ist.

4. Verfahren nach einem der Ansprüche 1 bis 3,
**dadurch gekennzeichnet, dass** zur Erstellung der ersten Defektkarte ein erster Wert (δ₁) der Defektdichte von 3/8 verwendet wird, d. h. drei von acht eine als defekt klassifizierte bzw. identifizierte Einzelkomponente umgebenden Einzelkomponenten sind als defekt klassifiziert bzw. identifiziert.

5. Verfahren nach einem der vorhergehenden Ansprüche,
**dadurch gekennzeichnet, dass** zur Erstellung der dritten Defektkarte ein zweiten Wert (δ₂) der Defektdichte von 2/8 verwendet wird, d. h. zwei von acht eine als defekt klassifizierte bzw. identifizierte Einzelkomponente umgebenden Einzelkomponenten sind als defekt klassifiziert bzw. identifiziert.

6. Verfahren nach einem der Ansprüche 3 bis 5,
**dadurch gekennzeichnet, dass** zur Erstellung der fünften Defektkarte ein dritter Wert (δ₃) der Defektdichte von 5/8 verwendet wird, d.h. fünf von acht eine als defekt klassifizierte bzw. identifizierte Einzelkomponente umgebenden Einzelkomponenten sind als defekt klassifiziert bzw. identifiziert.

7. Verfahren nach einem der vorangehenden Ansprüche,
**dadurch gekennzeichnet, dass** die defekten Einzelkomponenten als auch die zusätzlich als defekt klassifizierten Einzelkomponenten optisch markiert werden.

8. Verfahren nach Anspruch 7,
**dadurch gekennzeichnet, dass** die Einzelkomponenten mittels eines Farbpunktes markiert werden.

9. Verfahren nach einem der vorhergehenden Ansprüche,
**dadurch gekennzeichnet, dass** als Träger Halbleiter-Wafer mit Halbleiter-Bauelementen als Einzelkomponenten vorgesehen sind.

10. Verfahren nach Anspruch 9,
**dadurch gekennzeichnet, dass** Halbleiter-Wafer mit integrierten Schaltungen als Halbleiter-Bauelemente verwendet werden.

11. Prober, insbesondere Wafer-Prober mit einer Steuereinrichtung zur Durchführung des Verfahrens nach einem der vorangehenden Ansprüche,
**dadurch gekennzeichnet, dass**
- die Koordinaten einer jeden Einzelkomponente auf dem Träger bestimmt und in einem 2-dimensionalen Feld eines Speichers der Steuereinrichtung gespeichert wird,
- alle Einzelkomponenten elektrisch getestet werden und defekte Einzelkomponenten als defekt in dem ersten 2-dimensionalen Feld gekennzeichnet werden,
- Erstellen der ersten und zweiten Defektkarte aus dem ersten 2-dimensionalen Feld und deren Speicherung in dem Speicher der Steuereinrichtung,
- Erstellen der dritten Defektkarte aus der zweiten Defektkarte und anschließend vereinigen der dritten Defektkarte mit der ersten Defektkarte zur Erstellung der vierten Defektkarte, und
- Speicherung der vierten Defektkarte zur Ausgabe der Koordinaten der als defekt gekennzeichneten Einzelkomponenten an eine Markierungsvorrichung zur Markierung der entsprechenden Einzelkomponenten auf dem Träger.
